# EUROPEAN PATENT APPLICATION

(11) **EP 4 513 744 A1**
(43) Date of publication of application: **26.02.2025**
(21) Application number: 23806560.1
(22) Date of filing: 02.03.2023
(51) Int. Cl.: H02P 29/00, H02P 29/68, H02P 25/00, H05K 7/20

(54) **MOTOR CONTROLLER, POWER SYSTEM, AND ELECTRIC APPARATUS**

(30) Priority: 18.05.2022 CN 202221198682 U
(71) Applicant: Contemporary Amperex Technology Co., Limited, Ningde City, Fujian PRC 352100 (CN)
(72) Inventor: LIU, Tian, Ningde, Fujian 352100 (CN); ZHAO, Yuanmiao, Ningde, Fujian 352100 (CN); YAN, Yu, Ningde, Fujian 352100 (CN); WANG, Chunfa, Ningde, Fujian 352100 (CN); LI, Zhanliang, Ningde, Fujian 352100 (CN); HUANG, Yifei, Ningde, Fujian 352100 (CN)
(74) Representative: Gong, Jinping
(86) International application number: PCT/CN2023/079200
(87) International publication number: WO 2023/221600

(57) **Abstract**

This application discloses a motor controller, a power system, and an electric apparatus. The motor controller includes a box, a first power device, and a plurality of second power devices. The box is provided with a liquid coolant flow channel, and a liquid inlet and a liquid outlet that are in communication with the liquid coolant flow channel. The first power device is disposed in the box and on a side close to the liquid inlet. The plurality of second power devices are disposed in the box and on a side close to the liquid outlet. The second power devices have a smaller heating power than the first power device. A liquid coolant in the liquid coolant flow channel is capable of separately exchanging heat with the first power device and the plurality of second power devices. The first power device having larger heating power is disposed on a side close to the liquid inlet, and the plurality of second power devices having smaller heating power are disposed on a side close to the liquid outlet, so that the liquid coolant is used to first cool the first power device and then the plurality of second power devices, thereby improving a cooling effect for the motor controller, and meeting use requirements in various operating conditions.

## Description

### CROSS-REFERENCE TO RELATED APPLICATIONS

This application claims priority to Chinese patent application 202221198682.8, filed on May 18, 2022 and entitled "MOTOR CONTROLLER, POWER SYSTEM, AND ELECTRIC APPARATUS", which is incorporated herein by reference in its entirety.

### TECHNICAL FIELD

This application relates to the field of electric vehicle technologies, and in particular, to a motor controller, a power system, and an electric apparatus.

### BACKGROUND

This part provides only the background information related to this disclosure but it is not necessarily the prior art.

With the development of new energy, new energy is used as a power source in more and more fields. With the advantages such as high energy density, support of cyclic charging, safety, and environment friendliness, batteries are widely used in fields such as new energy vehicles, consumer electronics, and energy storage systems.

In low-temperature environments, batteries have severe degradation in discharge capacity and are unable to be charged. Therefore, in order to use batteries normally in low-temperature environments, it is necessary to heat the batteries in low-temperature environments. In the prior art, motor controllers and motors are used to excite batteries to generate positive and negative alternating currents, which not only improves the operating temperature of traction batteries and maximizes battery performance, but also realizes battery heating through electronic control of motors of electric vehicles.

Taking a three-leg motor controller as an example, in order to improve a heating effect, the motor controller is additionally provided with a fourth leg on the basis of original legs, with all the other three legs connected in series with the fourth leg. The current in the fourth leg is a sum of the currents in the other three legs, and a larger amount of heat is generated in the fourth leg. However, existing cooling solutions cannot meet cooling requirements of the fourth leg, making it impossible to guarantee the cooling effect for the motor controller.

### SUMMARY

An objective of this application is to at least solve the problem that the cooling effect for the existing motor controllers cannot be guaranteed. This objective is achieved through the following solutions.

According to a first aspect, this application proposes a motor controller. The motor controller includes:
a box, where the box is provided with a liquid coolant flow channel, and a liquid inlet and a liquid outlet that are in communication with the liquid coolant flow channel;
a first power device, where the first power device is disposed in the box and on a side close to the liquid inlet; and
a plurality of second power devices, where the plurality of second power devices are disposed in the box and on a side close to the liquid outlet; the second power devices have a smaller heating power than the first power device; and a liquid coolant in the liquid coolant flow channel is capable of separately exchanging heat with the first power device and the plurality of second power devices.

According to the motor controller in this application, the first power device and the plurality of second power devices are both disposed in the box, where the first power device is disposed on a side close to the liquid inlet, and the plurality of second power devices are disposed on a side close to the liquid outlet. During use of the motor controller, the liquid coolant is delivered from the liquid inlet to the liquid coolant flow channel, and the liquid coolant flows toward the liquid outlet in the liquid coolant flow channel. During flowing, the liquid coolant separately exchanges heat with the first power device and all the second power devices, thereby reducing temperatures of the first power device and the plurality of second power devices. The first power device having larger heating power is disposed on a side close to the liquid inlet, and the plurality of second power devices having smaller heating power are disposed on a side close to the liquid outlet. When the liquid coolant enters the liquid coolant flow channel through the liquid inlet, the liquid coolant is at a low temperature and has a large temperature difference with the first power device, so the liquid coolant first cools the first power device and then the plurality of second power devices. Thus, a cooling effect for the motor controller is improved, allowing the motor controller to meet use requirements in various operating conditions.

In addition, the motor controller in this application may further have the following additional technical features.

In some embodiments of this application, the box is provided with an auxiliary cooling structure, where the auxiliary cooling structure is disposed corresponding to the liquid coolant flow channel. The provision of the auxiliary cooling structure can further improve the cooling effect for each power device, such that the cooling effect for the motor controller is guaranteed, thereby ensuring that the motor controller can meet use requirements in various operating conditions.

In some embodiments of this application, the auxiliary cooling structure includes a plurality of turbulation structures, where the plurality of turbulation structures are spaced apart in the liquid coolant flow channel. The plurality of turbulation structures are provided for turbulation of the liquid coolant, such that turbulence intensity of the liquid coolant is enhanced, thereby improving the capability of heat transfer between the liquid coolant and each power device, and further improving the cooling effect for each power device.

In some embodiments of this application, a quantity of the turbulation structures corresponding to the first power device is greater than a quantity of the turbulation structures corresponding to any one of the second power devices. The first power device has larger heating power than any one of the second power devices. Therefore, setting the distribution of the turbulation structures further improves the turbulence intensity of the liquid coolant at a position of the liquid coolant flow channel corresponding to the first power device, such that the effect of heat transfer between the liquid coolant and the first power device is further improved.

In some embodiments of this application, the turbulation structure is a turbulation column or a turbulation rib. While guaranteeing the turbulation of the liquid coolant, the turbulation column or turbulation rib has a simple structure, facilitates processing and manufacturing, and effectively reduces manufacturing costs.

In some embodiments of this application, the auxiliary cooling structure further includes an air cooling structure, where the air cooling structure is disposed on the box and correspondingly disposed at an outer side of the liquid coolant flow channel. The air cooling structure exchanges heat with the liquid coolant in the liquid coolant flow channel through the liquid coolant flow channel, such that the liquid coolant with increased temperature is cooled, allowing for a large temperature difference between the liquid coolant and each power device, thereby guaranteeing the cooling effect of the liquid coolant for each power device.

In some embodiments of this application, the air cooling structure and the first power device are disposed at two opposite sides of the liquid coolant flow channel, and the air cooling structure is disposed corresponding to the first power device. The air cooling structure is disposed corresponding to the first power device, such that the liquid coolant that has exchanged heat with the first power device can be cooled to some extent, thereby guaranteeing the cooling effect for the second power device. In addition, arranging the air cooling structure and the first power device at two opposite sides of the liquid coolant flow channel can reduce the influence of the first power device on the cooling effect of the air cooling structure, thereby guaranteeing the cooling effect of the air cooling structure for the liquid coolant.

In some embodiments of this application, the air cooling structure is a plurality of cooling fins spaced apart, or the air cooling structure is a plurality of cooling rib plates spaced apart. The air cooling structure is a plurality of cooling fins spaced apart or a plurality of cooling rib plates spaced apart, which has a simple structure and can effectively guarantee the cooling effect for the liquid coolant.

In some embodiments of this application, the box includes:
a box body, where a flow channel groove is formed in the box body; and
a flow channel cover plate, where the flow channel cover plate is connected to the box body and closes an opening of the flow channel groove, and the flow channel cover plate and the flow channel groove enclose the liquid coolant flow channel.

The flow channel groove and the flow channel cover plate enclose the liquid coolant flow channel, so that the liquid coolant flow channel can be cleaned after the flow channel cover plate is removed, so as to solve the problem of the liquid coolant flow channel being blocked due to scaling or impurities of the liquid coolant.

In some embodiments of this application, the opening of the flow channel groove faces away from the first power device, and the air cooling structure is disposed on a side surface of the flow channel cover plate facing away from the flow channel groove. Arranging the air cooling structure on the flow channel cover plate eliminates the process of separately processing the air cooling structure, thereby reducing production costs.

In some embodiments of this application, the box further includes an upper cover, where the upper cover is connected to the box body and closes an opening of the box body. The upper cover fits with another opening of the box body, so that the power devices are packaged inside the box so as to be isolated from the outside.

In some embodiments of this application, the liquid inlet and the liquid outlet are provided on a same side of the box. The liquid inlet and the liquid outlet being provided on a same side surface of the box can facilitate pipeline connection during use, thereby improving the convenience during assembly.

In some embodiments of this application, the box is provided with an interface unit, where the first power device and the plurality of second power devices are each connected to an external device through the interface unit. The provision of the interface unit facilitates connection of the motor controller to other external devices during use, meeting connection requirements of the motor controller during use.

In some embodiments of this application, the box is further provided with a connecting structure, where the connecting structure is configured to fix the motor controller to a mounting position. The provision of the connecting structure facilitates mounting and fixation of the motor controller during use, improving the assembly efficiency.

According to a second aspect, this application proposes a power system. The power system includes: a motor, a traction battery, and the motor controller described above, where the motor is connected to the traction battery through the motor controller.

According to the power system of this application, in the motor controller, the first power device and the plurality of second power devices are both disposed in the box, where the first power device is disposed on a side close to the liquid inlet, and the plurality of second power devices are disposed on a side close to the liquid outlet. During use of the motor controller, the liquid coolant is delivered from the liquid inlet to the liquid coolant flow channel, and the liquid coolant flows toward the liquid outlet in the liquid coolant flow channel. During flowing, the liquid coolant separately exchanges heat with the first power device and all the second power devices, thereby reducing temperatures of the first power device and the plurality of second power devices. The first power device having larger heating power is disposed on a side close to the liquid inlet, and the plurality of second power devices having smaller heating power are disposed on a side close to the liquid outlet. When the liquid coolant enters the liquid coolant flow channel through the liquid inlet, the liquid coolant is at a low temperature and has a large temperature difference with the first power device, so the liquid coolant first cools the first power device and then the plurality of second power devices. Thus, a cooling effect for the motor controller is improved, allowing the motor controller to meet use requirements in various operating conditions.

According to a third aspect, this application proposes an electric apparatus, where the electric apparatus includes the power system described above.

According to the electric apparatus of this application, in the motor controller of the power system, the first power device and the plurality of second power devices are both disposed in the box, where the first power device is disposed on a side close to the liquid inlet, and the plurality of second power devices are disposed on a side close to the liquid outlet. During use of the motor controller, the liquid coolant is delivered from the liquid inlet to the liquid coolant flow channel, and the liquid coolant flows toward the liquid outlet in the liquid coolant flow channel. During flowing, the liquid coolant separately exchanges heat with the first power device and all the second power devices, thereby reducing temperatures of the first power device and the plurality of second power devices. The first power device having larger heating power is disposed on a side close to the liquid inlet, and the plurality of second power devices having smaller heating power are disposed on a side close to the liquid outlet. When the liquid coolant enters the liquid coolant flow channel through the liquid inlet, the liquid coolant is at a low temperature and has a large temperature difference with the first power device, so the liquid coolant first cools the first power device and then the plurality of second power devices. Thus, a cooling effect for the motor controller is improved, allowing the motor controller to meet use requirements in various operating conditions.

### BRIEF DESCRIPTION OF DRAWINGS

Persons of ordinary skill in the art can clearly understand various other advantages and benefits by reading the detailed description of the preferred embodiments below. The accompanying drawings are merely intended to illustrate the preferred embodiments and are not intended to limit this application. Moreover, throughout the accompanying drawings, same parts are denoted by same reference signs. In the accompanying drawings:
FIG. 1 illustratively shows a structure of a motor controller according to an embodiment of this application (an upper cover of a box is not shown);
FIG. 2 is a schematic structural diagram of a box body of a box of the motor controller shown in FIG. 1;
FIG. 3 is a schematic structural diagram of a flow channel cover plate of the box shown in FIG. 1; and
FIG. 4 is a schematic structural diagram of the motor controller shown in FIG. 1 from another perspective.

### Reference signs:

100. motor controller;
10. box;
11. box body; 111. flow channel groove; 12. liquid coolant flow channel; 13. liquid inlet; 14. liquid outlet; 15. connecting structure; 16. interface unit; 161. first interface; 162. second interface; 163. third interface; 164. fourth interface; 165. fifth interface; 166. sixth interface; 17. auxiliary cooling structure; 171. turbulation structure; 172. air cooling structure; 18. flow channel cover plate;
20. first power device;
21. first power module; 22. first drive plate; 23. first current transducer;
30. second power device;
31. second power module; 32. second drive plate; 33. second current transducer; and
40. bus capacitor.

### DESCRIPTION OF EMBODIMENTS

The following describes example embodiments of this disclosure in more detail with reference to the accompanying drawings. Although the example embodiments of this disclosure are shown in the accompanying drawings, it should be understood that this disclosure may be implemented in various forms and should not be limited by the embodiments described herein. On the contrary, these embodiments are provided to enable a more thorough understanding of this disclosure and completely convey the scope of this disclosure to persons skilled in the art.

It should be understood that the terms used herein are merely for description of particular exemplary embodiments rather than for limitation. Unless otherwise clearly specified in the context, the singular forms modified by "one", "a/an" and "the" as used in the specification may also indicate inclusion of the plural forms. The terms "include", "comprise", "contain", and "have" are non-exclusive and thus specify the presence of the stated features, steps, operations, elements, and/or components, which however do not preclude the presence or addition of one or more other features, steps, operations, elements, components, and/or combinations thereof. The method steps, processes, and operations described in the specification are not to be construed as necessarily requiring that they be executed in a particular order as is described or illustrated, unless the order of execution is clearly stated. It should also be understood that additional or alternative steps may be used.

Although the terms first, second, third, and the like may be used in the specification to describe multiple elements, components, zones, layers, and/or sections, these elements, components, zones, layers, and/or sections should not be limited to such terms. These terms may be used only for distinguishing one element, component, zone, layer, or section from another zone, layer, or section. Unless otherwise clearly specified in the context, terms such as "first", "second", and other numerical terms as used in the specification do not imply order or sequence. Accordingly, the first element, component, zone, layer, or section discussed below may be referred to as a second element, component, zone, layer, or section without departing from the instructions of the exemplary embodiments.

For ease of description, relative spatial relation terms may be used in the text to describe the relation of one element or feature to another element or feature as illustrated in the drawings. Such relation terms include, for example, "inside", "outside", "inner side", "outer side", "under", "below", "on", and "above". These relative spatial relation terms are intended to include different orientations of means in use or operation other than the orientations depicted in the drawings. For example, if the means in the figure is turned over, an element described as being "under other elements or features" or "below other elements or features" is then orientated as being "on other elements or features" or "above other elements or features". Therefore, the exemplary term "below..." may include both "above" and "below" orientations. The means can be orientated in other ways (rotated 90 degrees or in another direction), and the spatial relation description sign is correspondingly interpreted.

Currently, from the perspective of market development, application of traction batteries is becoming more extensive. Traction batteries have been not only used in energy storage power supply systems such as hydroelectric power plants, thermal power plants, wind power plants, and solar power plants, but also widely used in many other fields including electric transportation tools such as electric bicycles, electric motorcycles and electric vehicles, military equipment, and aerospace. With the continuous expansion of application fields of traction batteries, market demands for traction batteries are also expanding.

The inventors have noticed that in low-temperature environments, batteries have severe degradation in discharge capacity and cannot be charged. Therefore, in order to use batteries normally in low-temperature environments, it is necessary to heat the batteries in low-temperature environments. In the prior art, motor controllers and motors are used to excite batteries to generate positive and negative alternating currents, which not only improves the operating temperature of traction batteries and maximizes battery performance, but also realizes battery heating through electronic control of motors of electric vehicles.

Taking a three-leg motor controller as an example, in order to improve a heating effect, the motor controller is additionally provided with a fourth leg on the basis of original legs, with all the other three legs connected in series with the fourth leg. The current in the fourth leg is a sum of the currents in the other three legs, and a larger amount of heat is generated in the fourth leg. However, existing cooling solutions cannot meet cooling requirements of the fourth leg, making it impossible to guarantee the cooling effect for the motor controller.

Based on the above consideration, to solve the problem that the cooling effect for the existing motor controllers cannot be guaranteed, the inventors have designed a motor controller 100 through in-depth research, where a first power device 20 having larger heating power is disposed on a side close to a liquid inlet 13 in communication with a liquid coolant flow channel 12, and a plurality of second power devices 30 having smaller heating power are disposed on a side close to a liquid outlet 14 in communication with the liquid coolant flow channel 12. When a liquid coolant enters the liquid coolant flow channel 12 through the liquid inlet 13, the liquid coolant is at a low temperature and has a large temperature difference with the first power device 20, so the liquid coolant first cools the first power device 20 and then the plurality of second power devices 30. Thus, a cooling effect for the motor controller 100 is improved.

In addition, a plurality of turbulation structures 171 of an auxiliary cooling structure 17 are disposed in the liquid coolant flow channel 12 and implement turbulation of the liquid coolant so as to enhance turbulence intensity of the liquid coolant, thereby improving heat exchange capability of the liquid coolant. Moreover, more turbulation structures 171 are disposed at a position corresponding to the first power device 20 to further improve the cooling effect for the first power device 20 having larger heating power.

In addition, a plurality of air cooling structures 172 of the auxiliary cooling structure 17 are connected to an outer side of the liquid coolant flow channel 12, so that the liquid coolant and the liquid coolant flow channel 12 are cooled by air cooling. The cooling effect is enhanced by air cooling plus liquid cooling, thus further improving the cooling effect.

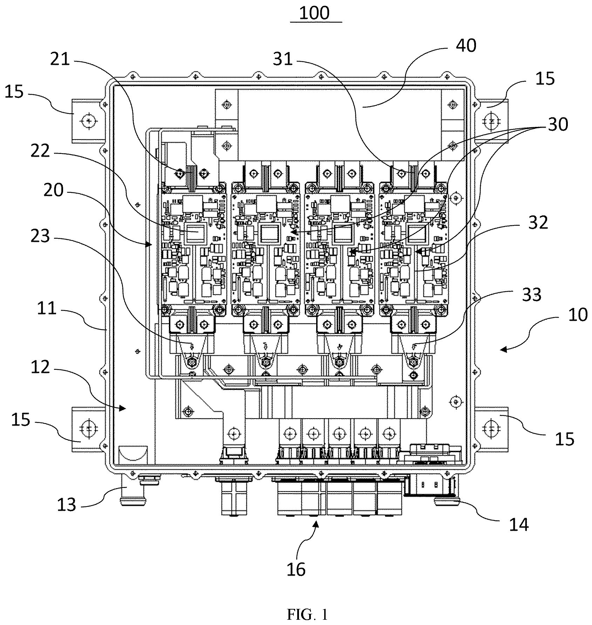

As shown in FIG. 1 to FIG. 4, an embodiment of this application proposes a motor controller 100. The motor controller 100 includes a box 10, a first power device 20, and a plurality of second power devices 30. The box 10 is provided with a liquid coolant flow channel 12, and a liquid inlet 13 and a liquid outlet 14 that are in communication with the liquid coolant flow channel 12. The first power device 20 is disposed in the box 10 and on a side close to the liquid inlet 13. The plurality of second power devices 30 are disposed in the box 10 and on a side close to the liquid outlet 14. The second power devices 30 have a smaller heating power than the first power device 20. A liquid coolant in the liquid coolant flow channel 12 is capable of separately exchanging heat with the first power device 20 and the plurality of second power devices 30.

Specifically, as shown in FIG. 1, the first power device 20 and the plurality of second power devices 30 are both disposed in the box 10, where the first power device 20 is disposed on a side close to the liquid inlet 13, and the plurality of second power devices 30 are disposed on a side close to the liquid outlet 14. During use of the motor controller 100, the liquid coolant is delivered from the liquid inlet 13 to the liquid coolant flow channel 12, and the liquid coolant flows toward the liquid outlet 14 in the liquid coolant flow channel 12. During flowing, the liquid coolant separately exchanges heat with the first power device 20 and all the second power devices 30, thereby reducing temperatures of the first power device 20 and the plurality of second power devices 30. The first power device 20 having larger heating power is disposed on a side close to the liquid inlet 13, and the plurality of second power devices 30 having smaller heating power are disposed on a side close to the liquid outlet 14. When the liquid coolant enters the liquid coolant flow channel 12 through the liquid inlet 13, the liquid coolant is at a low temperature and has a large temperature difference with the first power device 20, so the liquid coolant first cools the first power device 20 and then the plurality of second power devices 30. Thus, a cooling effect for the motor controller 100 is improved, allowing the motor controller 100 to meet use requirements in various operating conditions.

In this application, the motor controller 100 is configured to control a corresponding executing element, where the executing element may be an engine, a motor driven by a traction battery, or the like. In this embodiment, the motor controller 100 being configured to control a motor driven by a traction battery is used as an example for specific description.

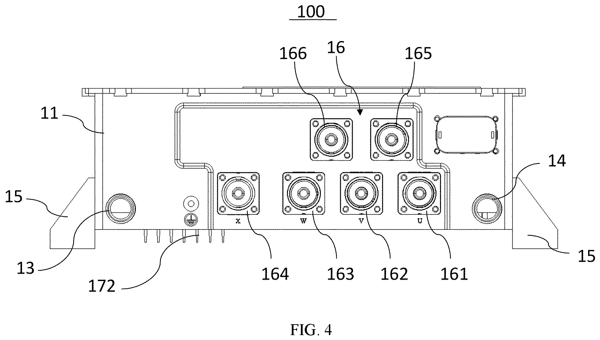

In this embodiment, as shown in FIG. 1 and FIG. 4, the motor controlled by the motor controller 100 is a three-phase motor, three second power devices 30 are provided in the motor controller 100, and the three second power devices 30 are respectively connected to three phases of the motor. Specifically, in the box 10, the three second power devices 30 are separately connected in parallel with an input terminal of a bus capacitor 40 of the motor controller 100 through a copper bar, and the first power device 20 is connected in series with an output terminal of the bus capacitor 40 through a copper bar.

Further, the box 10 is provided with an interface unit 16, where the first power device 20 and the plurality of second power devices 30 are connected to an external device through the interface unit 16.

Specifically, as shown in FIG. 1 and FIG. 4, the box 10 is provided with the interface unit 16. The interface unit 16 includes a first interface 161, a second interface 162, a third structure, a fourth interface 164, a fifth interface 165, and a sixth interface 166 (the six interfaces may be coplanar on the box 10 or not coplanar on the box 10). A 1^{st} second power device 30 is connected to a U phase of the motor through the first interface 161 (in the box 10, the 1^{st} second power device 30 is connected to the first interface 161 through a copper bar); a 2^{nd} second power device 30 is connected to a V phase of the motor through the second interface 162 (in the box 10, the 2^{nd} second power device 30 is connected to the second interface 162 through a copper bar); a 3^{rd} second power device 30 is connected to a W phase of the motor through the third interface 163 (in the box 10, the 3^{rd} second power device 30 is connected to the second interface 162 through a copper bar); the first power device 20 is connected to the traction battery through the fourth interface 164; the fifth interface 165 is a high-voltage positive electrode interface; and the sixth interface 166 is a high-voltage negative electrode interface.

In addition, in this embodiment, as shown in FIG. 1, the first power device 20 includes a first power module 21, a first drive plate 22, and a first current transducer 23; and the second power device 30 includes a second power module 31, a second drive plate 32, and a second current transducer 33.

Moreover, as shown in FIG. 1, FIG. 2, and FIG. 4, the box 10 is further provided with a connecting structure 15. The connecting structure 15 is configured to fasten the motor controller 100 to a mounting position. Specifically, the connecting structure 15 may be a lug that is formed on an outer surface of the box 10 and that has a connecting hole, or may be a buckle disposed on the outer surface of the box 10. In a specific implementation process of this application, the connecting structure 15 is a lug having a connecting hole (the lug may be integrally formed with the box 10 or connected and fastened to the outer surface of the box 10 through welding or adhesion). When the motor controller 100 needs to be mounted and fastened, the motor controller 100 is placed at the mounting position, and a fastener (a screw, a bolt, or the like) is led through the connecting hole in the lug and then connected and fastened to a fastening structure (a threaded hole, a polish hole, or the like) at the mounting position. The motor controller 100 is connected using the connecting structure 15 that is a lug having the connecting hole, which is simple in structure and easy to mount and dismount, improving the convenience for mounting and dismounting the motor controller 100. Besides, a plurality of lugs having a connecting hole are provided (four lugs are shown in the drawings of the specification), and all the lugs are spaced apart along a circumferential direction of the box 10. The provision of the plurality of lugs having a connecting hole can enhance strength of connection and fastening of the motor controller 100, thereby guaranteeing the stability of connection and fastening of the motor controller 100.

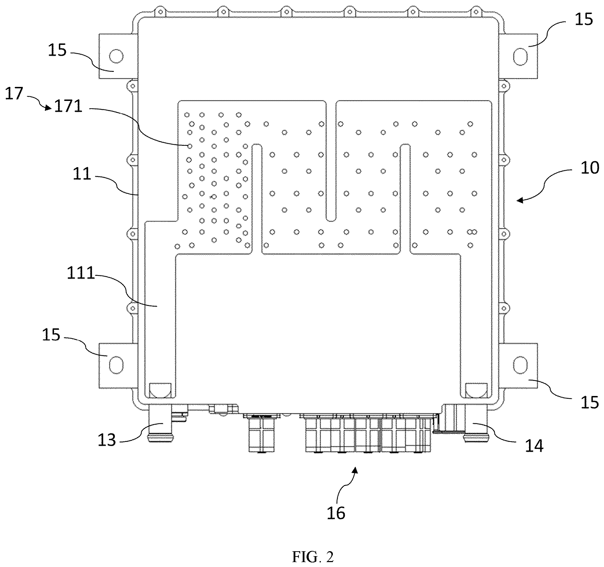

Further, as shown in FIG. 1, the first power device 20 and the three second power devices 30 are disposed side by side. The first power device 20 is disposed on a side close to the liquid inlet 13 and is attached to an outer wall of the liquid coolant flow channel 12 (in other embodiments, the first power device 20 may alternatively be in contact with the outer wall of the liquid coolant flow channel 12 through another heat transfer component). One second power device 30 is close to the liquid outlet 14, and the remaining second power devices 30 are disposed side by side between this second power device 30 and the liquid outlet 14 (in this embodiment, the second power devices 30 are attached to the outer wall of the liquid coolant flow channel 12; and in other embodiments, the first power device 20 may be in contact with the outer wall of the liquid coolant flow channel 12 through another heat transfer component). The liquid coolant flow channel 12 covers the first power device 20 and the three second power devices 30 entirely, to be specific, the liquid coolant flow channel 12 has regions provided corresponding to the first power device 20 and the three second power devices 30, so as to meet cooling requirements of the first power device 20 and the three second power devices 30. In this embodiment, as shown in FIG. 1 and FIG. 2, the liquid coolant flow channel 12 is a serpentine structure. Arranging the liquid coolant flow channel 12 as a serpentine structure can meet the cooling requirements of the first power device 20 and the three second power devices 30 that are disposed side by side. In addition, arranging the liquid coolant flow channel 12 as a serpentine structure can increase the length of the liquid coolant flow channel 12, such that the liquid coolant flows in a longer flowing route, prolonging the time for heat exchange between the liquid coolant and each power device, thereby further improving the cooling effect for each power device.

It should be noted that in other embodiments of this application, the first power device 20 and the three second power devices 30 may alternatively be arranged in other manners. For example, the three second power devices 30 are stacked (two adjacent second power devices 30 are separated, and the liquid coolant flow channel 12 runs through the two adjacent power devices); the first power device 20 and one of the second power devices 30 are arranged side by side; the liquid coolant flow channel 12 needs to be structurally adjusted based on a specific arrangement manner of the first power device 20 and the three second power devices 30; and an extension structure of the flow channel may be a linear structure, an arc-shaped structure, a helical structure, or another structure. This is not described in detail herein in this application.

Further, as shown in FIG. 1, FIG. 2, and FIG. 4, the liquid inlet 13 and the liquid outlet 14 are both provided on the box 10. In the box 10, the liquid inlet 13 and the liquid outlet 14 are in communication with the liquid coolant flow channel 12 of the box 10. Outside the box 10, the liquid inlet 13 and the liquid outlet 14 are each configured to be connected to a liquid coolant supply apparatus through a pipeline, so as to ensure that a low-temperature liquid coolant outputted by the liquid coolant supply apparatus enters the liquid coolant flow channel 12 through the liquid inlet 13 and also ensure that the liquid coolant in the liquid coolant flow channel 12 flows back to the liquid coolant supply apparatus through the liquid outlet 14 after heat exchange. Specifically, the liquid inlet 13 is a first tubular structure, and the liquid outlet 14 is a second tubular structure. When the liquid coolant supply apparatus needs to be connected, one pipeline is used to sleeve the first tubular structure (a first hold-back structure such as a first bulge ring may be disposed on an outer circumferential surface of the first tubular structure so as to prevent the pipeline from falling off), and another pipeline is used to sleeve the second tubular structure (a second hold-back structure such as a second bulge ring may be disposed on an outer circumferential surface of the second tubular structure so as to prevent the pipeline from falling off), so as to implement communication between the liquid coolant supply apparatus and the liquid coolant flow channel 12 simply and quickly.

Further, in this embodiment, the liquid inlet 13 and the liquid outlet 14 are provided on a same side of the box 10. As shown in FIG. 1 to FIG. 3, the box 10 is of a rectangular structure. The box 10 of a rectangular structure includes a plurality of side surfaces. The liquid inlet 13 and the liquid outlet 14 are provided on a same side surface of the box 10 (in other embodiments of this application, the liquid inlet 13 and the liquid outlet 14 may be provided on different side surfaces of the box 10, and corresponding adjustment may be specifically made according to requirements). The liquid inlet 13 and the liquid outlet 14 being provided on a same side surface of the box 10 facilitates pipeline connection during use, thereby improving the convenience in assembly. In addition, corresponding marks can be set at positions of the liquid inlet 13 and the liquid outlet 14 (for example, Chinese labels may be set, such as a label reading "liquid inlet 13" at the position of the liquid inlet 13 and a label reading "liquid outlet 14" at the position of the liquid outlet 14; or color marks are set, such as a blue dot at the position of the liquid inlet 13 and a red dot at the position of the liquid outlet 14, or the like), such that the liquid outlet 14 and the liquid inlet 13 can be accurately distinguished during pipeline connection, thereby avoiding misconnection.

It should be noted that as shown in FIG. 1, FIG. 2, and FIG. 4, the liquid inlet 13 and the liquid outlet 14 are provided on a same side surface of the box 10, the interface unit 16 (with all the interfaces of the interface unit 16 provided on a same side surface of the box 10) can be coplanar with the liquid inlet 13 and the liquid outlet 14 or not coplanar with the liquid inlet 13 and the liquid outlet 14. In this embodiment, the interface unit 16 is coplanar with the liquid inlet 13 and the liquid outlet 14, thereby facilitating connection operations during use of the motor controller 100 and facilitating wiring harness and pipeline layout.

Further, as shown in FIG. 2 to FIG. 4, the box 10 is provided with an auxiliary cooling structure 17, where the auxiliary cooling structure 17 is disposed corresponding to the liquid coolant flow channel 12. Specifically, the auxiliary cooling structure 17 is disposed in the liquid coolant flow channel 12 and cooperates with the liquid coolant flow channel 12. The auxiliary cooling structure 17 can act on the liquid coolant, allowing the liquid coolant to better exchange heat with the power devices and/or reducing temperature of the liquid coolant. The provision of the auxiliary cooling structure 17 can further improve the cooling effect for each power device, such that the cooling effect for the motor controller 100 is guaranteed, thereby ensuring that the motor controller 100 can meet use requirements in various operating conditions.

In this application, as shown in FIG. 2, the auxiliary cooling structure 17 includes at least one of a turbulation structure 171 and an air cooling structure 172. In this embodiment, the auxiliary cooling structure 17 includes a turbulation structure 171 and an air cooling structure 172, to improve the effect of the liquid coolant in cooling the power devices by combining turbulation and air cooling. The following provides specific description with reference to the drawings for the specification.

As shown in FIG. 2, the auxiliary cooling structure 17 includes a plurality of turbulation structures 171, where the plurality of turbulation structures 171 are spaced apart in the liquid coolant flow channel 12.

Further, the turbulation structures 171 are disposed in the liquid coolant flow channel 12, and when the liquid coolant enters the liquid coolant flow channel 12 through the liquid inlet 13 and flows toward the liquid outlet 14 along the liquid coolant flow channel 12, the turbulation structures 171 implement turbulation of the liquid coolant, such that turbulence intensity of the liquid coolant is enhanced, thereby improving the capability of the liquid coolant in exchanging heat with each power device, and further improving the cooling effect for each power device.

In addition, in this embodiment, as shown in FIG. 2, the turbulation structure 171 is provided in plurality, where all the turbulation structures 171 are disposed in the liquid coolant flow channel 12, and any two of the turbulation structures 171 are spaced apart. The provision of the plurality of turbulation structures 171 can further enhance the turbulence intensity of the liquid coolant during flowing, thereby further improving the capability for cooling each power device.

It should be understood that all the turbulation structures 171 can be evenly distributed in the liquid coolant flow channel 12 or distributed in a preset manner (unevenly).

In this embodiment, a quantity of the turbulation structures 171 corresponding to the first power device 20 is greater than a quantity of the turbulation structures 171 corresponding to any one of the second power devices 30.

As shown in FIG. 2, all the turbulation structures 171 are distributed in a preset manner, where the quantity of the turbulation structures 171 corresponding to the first power device 20 is greater than the quantity of the turbulation structures 171 corresponding to any one of the second power devices 30. The first power device 20 has larger heating power than any one of the second power devices 30. Therefore, setting distribution of the turbulation structures 171 further improves the turbulence intensity of the liquid coolant at a position of the liquid coolant flow channel 12 corresponding to the first power device 20, such that the effect of heat exchange between the liquid coolant and the first power device 20 is further improved to effectively reduce the power device having larger heating power in the motor controller 100 below an appropriate temperature, thereby preventing damage to the power device caused by high temperature.

It should be understood that a large quantity of the turbulation structures 171 corresponding to the first power device 20 means a high density of the turbulation structures 171 at the position corresponding to the first power device 20.

It should be noted that in this embodiment, the three second power devices 30 have the same heating power, so the quantities of turbulation structures 171 corresponding to the three second power devices 30 are equal.

In this embodiment, the turbulation structure 171 is a turbulation column or a turbulation rib.

In some implementation processes of this embodiment, as shown in FIG. 2, the turbulation structure 171 is specifically a turbulation column. The turbulation column is disposed in the liquid coolant flow channel 12 (the turbulation column may be integrally formed with the liquid coolant flow channel 12, or connected and fastened to the liquid coolant flow channel 12 through adhesion or welding), and an extension direction of the turbulation column is perpendicular to a flowing direction of the liquid coolant. When the liquid coolant flows to the position of the turbulation column, the turbulation column stops the liquid coolant, causing the liquid coolant to hit the turbulation column to form turbulent flows. With the increase in the turbulence intensity of the liquid coolant, the capability in exchanging heat with the power devices is improved, such that the cooling effect is improved.

It should be understood that the turbulation column may be a cylinder, a cone, a prism, or the like. In these implementation processes, the turbulation column is a cylinder, and the smooth surface of the cylinder can reduce obstruction to the liquid coolant while ensuring a turbulent flow effect of the liquid coolant, so as to guarantee flowability of the liquid coolant, allowing for good circulation of the liquid coolant. In addition, the turbulation column being a cylinder can reduce the processing difficulty and therefore reduce processing costs.

In some implementation processes of this embodiment, the turbulation structure 171 is specifically a turbulation rib. The turbulation rib is disposed in the liquid coolant flow channel 12 (the turbulation rib may be integrally formed with the liquid coolant flow channel 12 or connected and fastened to the liquid coolant flow channel 12 through adhesion or welding), and a height direction of the turbulation rib is perpendicular to the flowing direction of the liquid coolant. When the liquid coolant flows to the position of the turbulation rib, a turbulation surface of the turbulation rib stops the liquid coolant, causing the liquid coolant to hit the turbulation surface to form turbulent flows. With the increase in the turbulence intensity of the liquid coolant, the capability in exchanging heat with the power devices is improved, such that the cooling effect is improved.

It should be understood that the turbulation rib may be a straight rib plate or a curved rib plate. In these implementation processes, the turbulation rib is a straight rib plate, and a turbulation surface of the straight rib plate is at a preset angle (which is not 0° or 90°) with the flowing direction of the liquid coolant. The setting of the preset angle reduces obstruction of the turbulation rib to the liquid coolant so as to guarantee the flowability of the liquid coolant, allowing for good circulation of the liquid coolant.

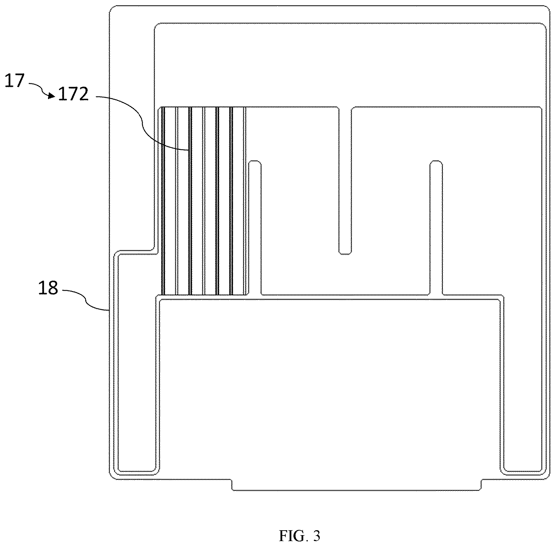

As shown in FIG. 3 and FIG. 4, the auxiliary cooling structure 17 further includes an air cooling structure 172, where the air cooling structure 172 is disposed on the box 10 and correspondingly disposed at an outer side of the liquid coolant flow channel 12. Specifically, the liquid coolant exchanges heat with each power device while flowing in the liquid coolant flow channel 12, such that the temperature of each power device is reduced, but the temperature of the liquid coolant rises. The air cooling structure 172 exchanges heat with the liquid coolant in the liquid coolant flow channel 12 through the liquid coolant flow channel 12, such that the liquid coolant with increased temperature is cooled, allowing for a large temperature difference between the liquid coolant and each power device, thereby guaranteeing the cooling effect of the liquid coolant for each power device.

It should be understood that the liquid coolant exchanges heat with the outside through the liquid coolant flow channel 12, and the air cooling structure 172 cools the outer side of the liquid coolant flow channel 12, such that heat transferred by the liquid coolant can be dissipated, thereby reducing the temperature of the liquid coolant.

Further, as shown in FIG. 2 to FIG. 4, the air cooling structure 172 and the first power device 20 are disposed at two opposite sides of the liquid coolant flow channel 12, and the air cooling structure 172 is disposed corresponding to the first power device 20.

Specifically, the first power device 20 has large heating power, and the first power device 20 is disposed close to the liquid inlet 13, so that the first power device 20 is cooled first using the liquid coolant at a low temperature. In this case, the temperature of the liquid coolant at the low temperature rises. If the liquid coolant with increased temperature is used to cool the subsequent three second power devices 30, the cooling effect cannot be guaranteed. Therefore, the air cooling structure 172 is disposed corresponding to the first power device 20, such that the liquid coolant with increased temperature can be cooled to some extent, and its cooling effect can be guaranteed when it is used to cool the subsequent three second power devices 30.

It should be understood that the air cooling structure 172 and the first power device 20 are disposed at two opposite sides of the liquid coolant flow channel 12 to reduce influence of the first power device 20 on the cooling effect of the air cooling structure 172, thereby ensuring the cooling effect of the air cooling structure 172 for the liquid coolant.

It should be noted that in other embodiments of this application, the air cooling structure 172 and the first power device 20 may not be disposed at two opposite sides of the liquid coolant flow channel 12. For example, they are disposed at two adjacent sides, so as to meet the requirements of mounting and arrangement by adjusting arrangement positions of the first power device 20 and the air cooling structure 172.

In addition, to further improve the cooling effect for the power devices, the air cooling structure 172 may cover the entire liquid coolant flow channel 12.

In this embodiment, the air cooling structure 172 is a plurality of cooling fins spaced apart, or the air cooling structure 172 is a plurality of cooling rib plates spaced apart.

In some implementation processes of this embodiment, as shown in FIG. 3 and FIG. 4, the air cooling structure 172 includes cooling fins. The cooling fins are connected to the box 10 (connected and fastened to the box 10 through adhesion or welding), and exchange heat with the liquid coolant through the liquid coolant flow channel 12. The cooling fins are light and thin, have a large cooling surface, and therefore can allow the liquid coolant to be cooled quickly, thereby improving the cooling effect for the liquid coolant.

In addition, in these implementation processes, a plurality of cooling fins are provided, and any two of the turbulation structures 171 are spaced apart. The provision of the plurality of cooling fins can further improve the capability for cooling the liquid coolant, such that the cooling effect for the liquid coolant is further improved, and thus the capability for cooling each power device is further improved.

In some implementation processes of this embodiment, the air cooling structure 172 includes cooling rib plates. The cooling rib plates are connected to the box 10 (connected and fastened to the box 10 through integral formation, adhesion or welding with the box 10), and exchange heat with the liquid coolant through the liquid coolant flow channel 12. With high strength, the cooling rib plates can enhance their strength while cooling the liquid coolant, improving the capability of withstanding impact without deformation, thereby ensuring the cooling effect for the liquid coolant.

In addition, in these implementation processes, a plurality of cooling rib plates are provided, and any two of the turbulation structures 171 are spaced apart. The provision of the plurality of cooling rib plates can further improve the capability for cooling the liquid coolant, such that the cooling effect for the liquid coolant is further improved, and thus the capability for cooling each power device is further improved.

In some implementation processes of this embodiment, the air cooling structure 172 is a cooling fan disposed on the box 10 (connected and fastened to the box 10 through a connecting member). The cooling fan is used to blow cold air to a position of a liquid coolant channel so as to cool the liquid coolant. The manner of using the cooling fan to actively cool the liquid coolant can further ensure the cooling effect for the liquid coolant, such that the liquid coolant can cool each power device better so as to ensure that temperature rise of the motor controller 100 can meet use requirements, thereby allowing the motor controller 100 to be applicable to different operating conditions.

Further, the box 10 includes a box body 11 and a flow channel cover plate 18. A flow channel groove 111 is formed in the box body 11, the flow channel cover plate 18 is connected to the box body 11 and closes an opening of the flow channel groove 111, and the flow channel cover plate 18 and the flow channel groove 111 enclose the liquid coolant flow channel 12.

As shown in FIG. 2 to FIG. 4, the box 10 includes the box body 11 and the flow channel cover plate 18, where the box body 11 is a structure with two open ends; the flow channel groove 111 is formed on a partition plate of the box body 11, and the opening of the flow channel groove 111 faces one opening of the box 10; and when the flow channel cover plate 18 fits with the box 10, the flow channel cover plate 18 closes one opening of the box 10 and also closes the opening of the flow channel groove 111.

It should be understood that the flow channel cover plate 18 and the flow channel groove 111 fit with each other to form the liquid coolant flow channel 12 (the flow channel cover plate 18 is connected and fastened to the box body 11 through a fastener such as a screw, and a sealing member is disposed at a joint between the flow channel cover plate 18 and the flow channel groove 111 so as to prevent leakage of the liquid coolant), so that the liquid coolant flow channel 12 can be cleaned after the flow channel cover plate 18 is removed, thereby solving the problem of the liquid coolant flow channel 12 being blocked due to scaling or impurities of the liquid coolant.

Further, the box further includes an upper cover (not shown in the figure), and the upper cover is connected to the box body and closes an opening of the box body 11. The power devices are mounted at a side of the partition plate back away from the flow channel groove 111, and the upper cover fits with another opening of the box body 11, so that the power devices are packaged inside the box 10 and isolated from the outside.

The provision of the upper cover can effectively implement packaging of the power devices so as to prevent damage caused by impact on the power devices. The upper cover is connected and fastened to the box body 11 (a sealing structure such as a sealing ring is disposed at a joint therebetween so as to prevent damage to the power devices caused by water inflow) through a flange structure. Such connection and fastening manner can ensure connection strength between the upper cover and the box body 11.

It should be noted that as shown in FIG. 3, the turbulation structures 171 may be disposed on the flow channel cover plate 18 (a side of the flow channel cover plate 18 facing the flow channel groove 111) or disposed in the flow channel groove 111. In this embodiment, the turbulation structures 171 are disposed in the flow channel groove 111 to reduce the processing difficulty of the flow channel cover plate 18.

In this embodiment, the opening of the flow channel groove 111 faces away from the first power device 20, and the air cooling structure 172 is disposed on a side surface of the flow channel cover plate 18 facing away from the flow channel groove 111.

As shown in FIG. 3, the air cooling structure 172 is disposed on the side surface of the flow channel cover plate 18 facing away from the flow channel groove 111 and is disposed corresponding to the position of the first power device 20. With the air cooling structure 172 disposed on the flow channel cover plate 18, the air cooling structure 172 and the flow channel cover plate 18 can be integrally formed, eliminating the process of separately processing the air cooling structure 172, thereby reducing production costs.

This application further proposes a power system. The power system includes: a motor (not shown in the figure), a traction battery (not shown in the figure), and the motor controller 100 described above.

According to the power system of this application, in the motor controller, as shown in FIG. 1 to FIG. 4, the first power device 20 and the plurality of second power devices 30 of the motor controller 100 are both disposed in the box 10, where the first power device 20 is disposed on a side close to the liquid inlet 13, and the plurality of second power devices 30 are disposed on a side close to the liquid outlet 14. During use of the motor controller 100, the liquid coolant is delivered from the liquid inlet 13 to the liquid coolant flow channel 12, and the liquid coolant flows toward the liquid outlet 14 in the liquid coolant flow channel 12. During flowing, the liquid coolant separately exchanges heat with the first power device 20 and all the second power devices 30, thereby reducing temperatures of the first power device 20 and the plurality of second power devices 30. The first power device 20 having larger heating power is disposed on a side close to the liquid inlet 13, and the plurality of second power devices 30 having smaller heating power are disposed on a side close to the liquid outlet 14. When the liquid coolant enters the liquid coolant flow channel 12 through the liquid inlet 13, the liquid coolant is at a low temperature and has a large temperature difference with the first power device 20, so the liquid coolant at the low temperature first cools the first power device 20 and then the plurality of second power devices 30. Thus, a cooling effect for the motor controller 100 is improved, allowing the motor controller 100 to meet use requirements in various operating conditions.

This application further proposes an electric apparatus, where the electric apparatus includes the power system described above.

According to the power system of this application, in the motor controller of the power system, as shown in FIG. 1 to FIG. 4, the first power device 20 and the plurality of second power devices 30 of the motor controller 100 are both disposed in the box 10, where the first power device 20 is disposed on a side close to the liquid inlet 13, and the plurality of second power devices 30 are disposed on a side close to the liquid outlet 14. During use of the motor controller 100, the liquid coolant is delivered from the liquid inlet 13 to the liquid coolant flow channel 12, and the liquid coolant flows toward the liquid outlet 14 in the liquid coolant flow channel 12. During flowing, the liquid coolant separately exchanges heat with the first power device 20 and all the second power devices 30, thereby reducing temperatures of the first power device 20 and the plurality of second power devices 30. The first power device 20 having larger heating power is disposed on a side close to the liquid inlet 13, and the plurality of second power devices 30 having smaller heating power are disposed on a side close to the liquid outlet 14. When the liquid coolant enters the liquid coolant flow channel 12 through the liquid inlet 13, the liquid coolant is at a low temperature and has a large temperature difference with the first power device 20, so the liquid coolant at the low temperature first cools the first power device 20 and then the plurality of second power devices 30. Thus, a cooling effect for the motor controller 100 is improved, allowing the motor controller 100 to meet use requirements in various operating conditions.

It should be understood that in this application, the electric apparatus including the power system may be but is not limited to a mobile phone, a tablet computer, a laptop computer, an electric toy, an electric tool, an electric bicycle, an electric vehicle, a ship, and a spacecraft. The electric toy may include a fixed or mobile electric toy, for example, a game console, an electric toy car, an electric toy ship, and an electric toy aircraft. The spacecraft may include an aircraft, a rocket, a space shuttle, a spaceship, and the like.

The foregoing descriptions are merely specific embodiments of this application but are not intended to limit the protection scope of this application. Any variation or replacement readily figured out by persons skilled in the art within the technical scope disclosed in this application shall fall within the protection scope of this application. Therefore, the protection scope of this application shall be subject to the protection scope of the claims.

## Claims

1. A motor controller, **characterized in that** the motor controller comprises:
a box, wherein the box is provided with a liquid coolant flow channel, and a liquid inlet and a liquid outlet that are in communication with the liquid coolant flow channel;
a first power device, wherein the first power device is disposed in the box and on a side close to the liquid inlet; and
a plurality of second power devices, wherein the plurality of second power devices are disposed in the box and on a side close to the liquid outlet; the second power devices have a smaller heating power than the first power device; and a liquid coolant in the liquid coolant flow channel is capable of separately exchanging heat with the first power device and the plurality of second power devices.

2. The motor controller according to claim 1, **characterized in that** the box is provided with an auxiliary cooling structure, wherein the auxiliary cooling structure is disposed corresponding to the liquid coolant flow channel.

3. The motor controller according to claim 2, **characterized in that** the auxiliary cooling structure comprises a plurality of turbulation structures, wherein the plurality of turbulation structures are spaced apart in the liquid coolant flow channel.

4. The motor controller according to claim 3, **characterized in that** a quantity of the turbulation structures corresponding to the first power device is greater than a quantity of the turbulation structures corresponding to any one of the second power devices.

5. The motor controller according to claim 3, **characterized in that** the turbulation structure is a turbulation column or a turbulation rib.

6. The motor controller according to claim 2, **characterized in that** the auxiliary cooling structure further comprises an air cooling structure, wherein the air cooling structure is disposed on the box and correspondingly disposed at an outer side of the liquid coolant flow channel.

7. The motor controller according to claim 6, **characterized in that** the air cooling structure and the first power device are disposed at two opposite sides of the liquid coolant flow channel, and the air cooling structure is disposed corresponding to the first power device.

8. The motor controller according to claim 6, **characterized in that** the air cooling structure is a plurality of cooling fins spaced apart, or the air cooling structure is a plurality of cooling rib plates spaced apart.

9. The motor controller according to claim 6, **characterized in that** the box comprises:
a box body, wherein a flow channel groove is formed in the box body; and
a flow channel cover plate, wherein the flow channel cover plate is connected to the box body and closes an opening of the flow channel groove, and the flow channel cover plate and the flow channel groove enclose the liquid coolant flow channel.

10. The motor controller according to claim 9, **characterized in that** the opening of the flow channel groove faces away from the first power device, and the air cooling structure is disposed on a side surface of the flow channel cover plate facing away from the flow channel groove.

11. The motor controller according to claim 9, **characterized in that** the box further comprises an upper cover, wherein the upper cover is connected to the box body and closes an opening of the box body.

12. The motor controller according to claim 1, **characterized in that** the liquid inlet and the liquid outlet are provided on a same side of the box.

13. The motor controller according to claim 1, **characterized in that** the box is provided with an interface unit, wherein the first power device and the plurality of second power devices are each connected to an external device through the interface unit.

14. The motor controller according to claim 1, **characterized in that** the box is further provided with a connecting structure, wherein the connecting structure is configured to fix the motor controller to a mounting position.

15. A power system, **characterized in that** the power system comprises: a motor, a traction battery, and the motor controller according to any one of claims 1 to 14, wherein the motor is connected to the traction battery through the motor controller.

16. An electric apparatus, **characterized in that** the electric apparatus comprises the power system according to claim 15.
